Europäisches Patentamt

European Patent Office

Office européen des brevets

(19)

(11) Numéro de publication: **0 164 770**
**B1**

(12)

# FASCICULE DE BREVET EUROPEEN

(45) Date de publication du fascicule du brevet:
29.11.89

(51) Int. Cl.⁴: **H 03 K 17/18,** H 03 K 17/08,
H 03 K 17/60

(21) Numéro de dépôt: 85200634.5

(22) Date de dépôt: 24.04.85

(54) **Relais statique pour courant continu basse tension.**

(30) Priorité: **11.05.84 FR 8407308**

(43) Date de publication de la demande:
**18.12.85 Bulletin 85/51**

(45) Mention de la délivrance du brevet:
**29.11.89 Bulletin 89/48**

(84) Etats contractants désignés:
**DE FR GB IT**

(56) Documents cités:
DE-A- 2 750 972
GB-A- 966 598
US-A- 4 333 120

PATENTS ABSTRACTS OF JAPAN, vol. 8, no. 74, avril
1984, page 78 E 236; & JP - A - 58 222 554 (NISSAN
JIDOSHA K.K.) 24-12-1983
PATENTS ABSTRACTS OF JAPAN, vol. 8, no. 74, avril
1984, page 78 E 236; & JP - A - 58 222 555 (NISSAN
JIDOSHA K.K.) 24-12-1983
NASA CONTRACTOR REPORT, vol. CR-74, juillet 1964,
AVCO Corp., Washington, D.C., US; "A reentry voice
communication system for use in conjuction with radar
tracking equipment"

(73) Titulaire: **RTC-COMPELEC, 130, Avenue Ledru-Rollin,
F-75011 Paris (FR)**

(84) Etats contractants désignés: **FR**

(73) Titulaire: **N.V. Philips' Gloeilampenfabrieken,
Groenewoudseweg 1, NL-5621 BA Eindhoven (NL)**

(84) Etats contractants désignés: **DE GB IT**

(72) Inventeur: **Stroppiana, Robert, SOCIETE CIVILE
S.P.I.D. 209 Rue de l'Université, F-75007 Paris (FR)**

(74) Mandataire: **Jacquard, Philippe et al, SOCIETE CIVILE
S.P.I.D. 209, rue de l'Université, F-75007 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

# Description

La présente invention concerne un relais statique pour courant continu sous basse tension, destiné à l'alimentation d'une charge, comprenant un transistor bipolaire de sortie d'un premier type de conductivité dont l'émetteur est connecté à une borne de sortie destinée à alimenter la charge, laquelle est reliée par ailleurs à un pôle commun d'alimentation, dont le collecteur est relié à une borne dite principale d'alimentation destinée à être connectée à l'autre pôle de ladite alimentation, et dont la base est alimentée par le trajet principal de courant d'un transistor injecteur de courant, lequel présente une électrode de commande qui, lorsqu'elle est actionnée à partir d'une borne de commande entraîne sa mise en conduction ainsi que celle du transistor de sortie.

Un tel relais statique est utilisable notamment dans le domaine des installations électriques des véhicules automobiles, application dans laquelle il remplace avantageusement les systèmes classiques à relais électromagnétiques.

On connaît de la demande de brevet français 2 524 711 déposée par «General Electric Company – US» et publiée le 7 octobre 1983, un relais statique du type précité.

Un tel relais n'est pas adapté au cas des installations électriques des véhicules automobiles pour lesquelles les diverses ampoules doivent être alimentées par des transistors de commande à la tension nominale de la batterie, et pour lesquelles le circuit doit permettre d'identifier des anomalies relatives à la charge, à savoir non connexion, ou mise en court-circuit de celle-ci, et selon des modes préférés, contre des anomalies relatives à l'alimentation électrique du relais. De US-A 4 333 120 on connait un relais statique pour courant continu qui comporte un transistor à deux émetteurs connecté au transistor de sortie et indicatif de l'état de la charge.

D'autre part, le relais selon l'invention peut être réalisé sous forme de circuit intégré.

L'invention concerne ainsi un dispositif du type précité qui comporte un transistor bipolaire du second type de conductivité opposé au premier type, dit transistor de contrôle, dont le trajet émetteur-base augmenté d'une résistance de base est connecté en parallèle sur le trajet base-émetteur du transistor bipolaire de sortie et dont le collecteur produit un signal représentatif de l'état de la charge.

Le transistor de contrôle permet ainsi qu'il sera montré dans la suite de la description de disposer à partir de son collecteur d'un signal de contrôle fournissant des renseignements sur l'état de la charge, selon que celle-ci est normale, non-connectée ou court-circuitée.

Selon une forme de réalisation préférée, le transistor injecteur est relié à une borne d'alimentation auxiliaire.

La borne d'alimentation auxiliaire permet d'alimenter le transistor injecteur de courant avec une tension auxiliaire supérieure à la tension d'alimentation fournie à la borne dite principale, ce qui permet dans une application moyenne puissance telle que celle envisagée de palier aux pertes d'énergie jugées inacceptables, liées aux différentes chutes de tension inévitables.

La consommation énergétique du relais peut être diminuée en réalisant le transistor injecteur de courant sous forme de transistor à effet de champ MOS du type à enrichissement et à canal du second type de conductivité ayant sa grille, qui constitue ladite électrode de commande reliée par l'intermédiaire d'une résistance depolarisation à sa source, son drain alimentant la base du transistor bipolaire de sortie. En pratique, une limitation du courant base du transistor de sortie peut être obtenue de manière satisfaisante grâce à la résistance interne du transistor injecteur de courant, de telle sorte que le drain de ce dernier peut être reliée directement à la base de transistor de sortie.

Selon une première variante, la tension de commande reçue par la borne de commande est répercutée sur la grille du transistor injecteur et le collecteur du transistor de contrôle est reliée à la borne de commande par une première diode de protection disposée dans le sens normalement passant par le courant issue du collecteur du transistor de contrôle, de telle sorte que la borne de commande a également pour fonction de délivrer un signal de contrôle. Un circuit additionnel peut alors être prévu pour interrompre le fonctionnement du relais en cas d'anomalie. Une protection contre le débranchement de l'alimentation principale, par exemple la batterie d'un véhicule automobile, est réalisé grâce à un transistor de protection à effet de champ MOS dont la grille est connectée à la borne principale d'alimentation, dont la source est reliée à la borne de commande et dont le drain est relié à l'électrode de commande du transistor injecteur de courant.

De même, une protection contre l'inversion du sens de branchement de la tension principale d'alimentation peut être obtenue en disposant entre la source du transistor de protection et la borne de commande une deuxième diode de protection, montée dans le sens normalement passant du transistor de protection. Une protection contre les surtensions peut être également obtenue en disposant une troisième diode de protection en parallèle sur l'espace grille-source d'au moins un transistor MOS, et montée dans le sens inverse du sens passant de celui-ci.

La discrimination des différents états de fonctionnement du relais est avantageusement obtenue par un circuit de contrôle recevant le signal de contrôle présent à la borne de commande et le comparant à une pluralité de tensions de référence obtenues par division de la tension d'alimentation principale et correspondant aux différents états de fonctionnement et par un circuit d'inhibition de la mise en marche du relais quand un état de court-circuit est détecté par le circuit de contrôle.

Selon une deuxième variante constituant une variante préférée, le signal de commande est appliqué sur la grille d'un transistor de commande, et le signal de contrôle obtenu à partir du collecteur du transistor de contrôle est directement utilisé pour réaliser un auto-entretien du relais.

Le relais comporte à cet effet un transistor de commande dont la source est reliée à une borne de pôle commun, dont le drain est relié à l'électrode de commande du transistor injecteur de courant, et dont la grille est commandé à partir de la borne de commande et est reliée d'une part à la borne de mode commun par une résistance d'auto-entretien et d'autre part au collecteur du transistor de contrôle via une quatrième diode disposée dans le sens normalement passant par le courant issu du collecteur du transistor de contrôle de manière à appliquer sur la grille du transistor de commande une tension d'auto-entretien dans l'état normal de la charge.

Afin de protéger le relais en cas de coupure de l'alimentation principale, on dispose une résistance en série entre le drain de transistor de commande et l'électrode de commande du transistor injecteur de courant.

Une telle protection est cependant assurée de manière plus rationnelle par un transistor de protection à effet de champ MOS dont la grille est connectée à la borne principale d'alimentation, dont la source est reliée à la borne de commande et dont le drain est relié à l'électrode de commande du transistor injecteur de courant.

Selon un mode de réalisation, le relais fournit un signal de contrôle selon un état logique. Le relais comporte à cet effet un transistor de verrouillage, à enrichissement et à canal du premier type dont le trajet drain-source est branché en parallèle sur la résistance d'auto-entretien, et dont la grille est reliée à ladite borne de commande et, un circuit logique formé de deux transistors de contrôle MOS à effet de champ en série, à enrichissement et dont le type de canal est opposé l'un par rapport à l'autre, le premier ayant sa grille reliée à la borne de commande et le second ayant sa grille reliée à la grille du transistor injecteur de courant de manière à transmettre vers une borne logique de contrôle un signal de contrôle à deux états.

Le relais peut également être commandé par tout ou rien grâce à un circuit générateur d'impulsion calibrée comportant une première, et une deuxième résistance, chacune ayant une électrode connectée à la borne d'alimentation auxiliaire, et son autre électrode étant reliée respectivement à une électrode d'un condensateur, l'électrode commune au condensateur et à la deuxième résistance étant reliée à la grille d'un transistor à effet de champ MOS à enrichissement et à canal du second type de conductivité dont la source est reliée à la borne d'alimentation auxiliaire et le drain à la grille du transistor de commande, le point commun au condensateur et à la première résistance étant relié à la borne de commande de telle sorte que, lorsque la borne de commande est mise à la masse, le circuit générateur d'impulsion produise une impulsion de mise en marche.

Selon un premier mode de réalisation, le premier transistor du circuit logique a un canal du second type de conductivité et a son drain relié à la borne de pôle commun et sa source à celle du deuxième transistor du circuit logique, ce dernier ayant son drain connecté à la borne logique de contrôle.

Selon un second mode de réalisation, le premier transistor du circuit logique a un canal du second type de conductivité, et a son drain connecté à la borne logique de contrôle, et sa source à celle du second transistor dont le drain est connecté à la borne d'alimentation auxiliaire.

Selon une variante avantageuse, la borne de commande est attaquée par un transistor de commande logique à effet de champ MOS à enrichissement dont le trajet drain-source est branché entre la borne de pôle commun et la borne de commande de telle sorte que sa grille reçoive une commande logique par exemple TTL.

L'auto-entretien de relais peut être également réalisé en mettant en œuvre une seconde résistance d'auto-entretien disposée entre le collecteur du transistor de contrôle et l'électrode non à la masse de la première résistance d'auto-entretien, de manière à former avec celle-ci au pont diviseur.

L'invention sera mieux comprise à la lecture de la description qui va suivre, donnée à titre d'exemple non limitatif en liaison avec les figures qui représentent:

la figure 1a, est un schéma d'un relais selon l'invention, avec un transistor d'injection à effet de champ, celui-ci étant à la figure 1b du type bipolaire;

la figure 2a, une variante du relais selon l'invention selon laquelle la commande et le contrôle sont ramenés à une borne unique, la figure 2b étant un schéma équivalent illustrant la détection des défauts;

les figures 3a et 3b, deux variantes d'un interrupteur à transistor bipolaire utilisables pour commander le relais de la figure 2;

les figures 4a et 4b, respectivement une échelle des tensions recueillies à la borne de commande D de la figure 2 dans diverses configurations, et la courbe en fonction du temps du courant d'allumage débité par le transistor Ts dans une charge constituée par une ampoule électrique;

les figures 5a et 5b, respectivement pour chaque état du dispositif, la tension disponible à la borne D de la figure 2 en fonction des variations de la tension d'alimentation principale, et le faisceau des courbes obtenues en faisant varier également l'écart entre la tension d'alimentation principale et la tension d'alimentation auxiliaire;

la figure 6, un schéma logique d'exploitation des informations disponibles à la borne D de la figure 2;

la figure 7a, une seconde variante du relais selon l'invention selon laquelle le signal de contrôle est utilisé pour l'auto-entretien du relais, la figure 7b étant un schéma équivalent illustrant la détection des défauts.

Les figures 8 et 9, deux modes de réalisation conformes à la figure 7a dans lesquels la commande et le contrôle sont réalisés sous forme logique.

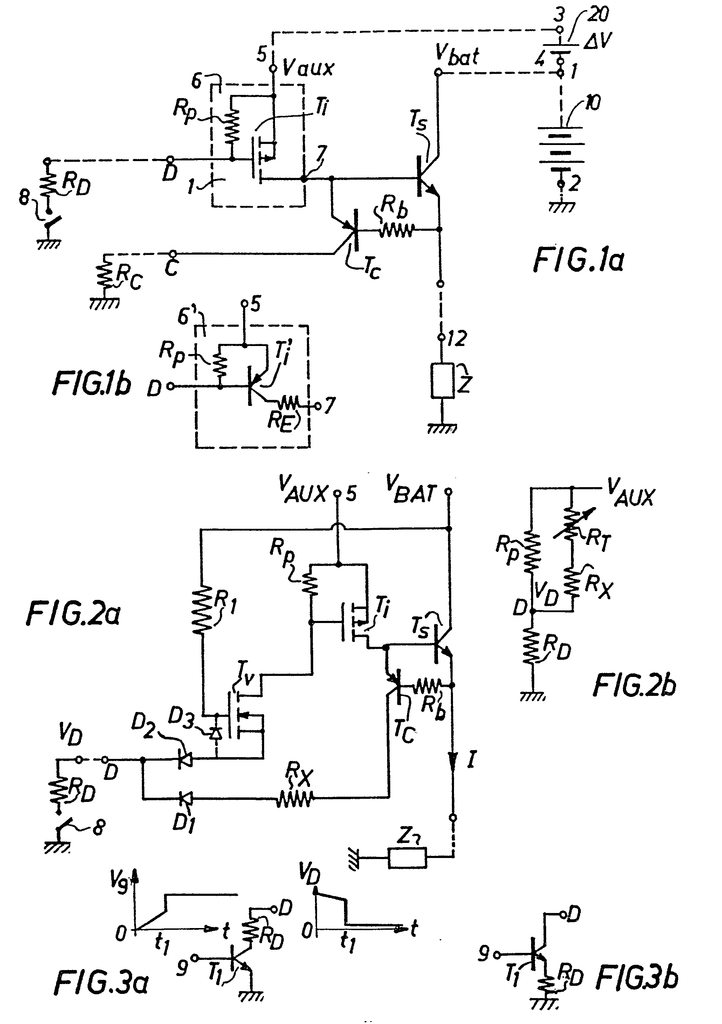

Sur la figure 1a, un transistor bipolaire Ts de type NPN dans l'exemple choisi, a son trajet émetteur-collecteur inséré entre une première borne 1 d'une alimentation principale 10 et une première connexion 12 d'une charge Z, l'autre borne 2 de l'alimentation et l'autre connexion de la charge étant reliées l'une et l'autre à un pôle de mode commun. L'alimentation principale est une alimentation continue à basse tension, dont la tension $V_{bat}$ a une valeur de 12 volts par exemple dans le cas d'une batterie.

Un générateur auxiliaire de tension 20 a sa première borne de sortie 3 connectée à la borne 5 d'un dispositif d'injection de courant 6 représenté sur la figure par un cadre en tirets, dispositif dont une autre borne 7 est connectée à la base du transistor bipolaire $T_s$. La deuxième borne de sortie 4 du générateur 20 est reliée à la première borne 1 de l'alimentation principale 10. La tension $V_{aux}$ fournie par le générateur auxiliaire 20 a une valeur peu élevée c'est-à-dire voisine, tout en étant supérieure, d'une valeur $\Delta V$, à la tension base-émetteur du transistor bipolaire $T_s$ lorsque ce transistor est conducteur. Une valeur de 2 Volts peut être citée à titre d'exemple.

De ce fait, la puissance dissipée en perte pour commander la base du transistor $T_s$ est réduite sensiblement dans le rapport de la tension $V_{aux}$ du générateur auxiliaire 20 à celle, $V_{bat}$, de l'alimentation principale 10.

Dans le cas de l'automobile, le générateur auxiliaire 20 est un convertisseur de tension du type à découpage, connu en soi, et tirant son énergie de la tension $V_{bat}$ de l'alimentation principale 10. Par contre, dans d'autres applications, on comprendra que la tension auxiliaire $V_{aux}$ peut être obtenue à l'aide par exemple d'une alimentation stabilisée indépendante.

Le dispositif de commande 6 comporte, en sortie, le trajet de courant source-drain d'un transistor à effet de champ $T_i$ dit transistor injecteur de courant, du type à enrichissement et à canal p, situé en série dans la liaison entre la base du transistor $T_s$ et la borne 3 du générateur auxiliaire 20.

Une résistance pourrait être, en outre, insérée en série dans ce circuit de manière à limiter à la valeur désirée le courant de base du transistor bipolaire $T_s$. Cependant, lorsque le transistor injecteur $T_i$ est porté à la conduction, sa résistance source-drain peut également tenir lieu de résistance de limitation, de sorte que sur la figure, aucune résistance additionnelle n'a été représentée. Dans le cas simple décrit à titre d'exemple, le dispositif de commande 6 est complété par un diviseur de tension à résistances $R_p$, $R_D$, en série avec un interrupteur de commande 8, placé sur la liaison raccordée au potentiel de référence $V_{aux}$ de l'alimentation auxiliaire 20. Le point D intermédiaire entre les résistances $R_p$ et $R_D$ qui constitue une borne de commande du relais, est porté à un potentiel dont la valeur dépend de l'état de l'interrupteur de commande 8. Il constitue donc un signal de commande pour le fonctionnement du circuit interrupteur, signal qui est appliqué sur la grille du transistor à effet de champ $T_i$.

Il est clair que tout autre circuit qui délivrerait un signal de commande avec les mêmes niveaux de tension à appliquer sur la grille du transistor à effet de champ $T_i$, conviendrait également. C'est ainsi que le dispositif de commande 6 pourrait se résenter sous des formes variées pour accomplir toutes sortes de fonctions de commutation, l'exemple décrit ici n'étant représentatif que d'un mode particulièrement simple et avantageux de mise en œuvre de l'invention. L'utilisation, dans tous les cas, d'un transistor à effet de champ en sortie du dispositif de commande est préférée du fait que, commandé par une tension, un tel type de transistor ne requiert aucune puissance sensible pour sa commande.

La figure 1b représente la seule partie du circuit interrupteur relative à un dispositif d'injecteur de courant 6, très voisin de celui de la figure 1a, mais dans une version à transistor bipolaire au lieu du transistor à effet de champ. Les éléments correspondants à ceux de la figure 1a portent les mêmes références numériques.

A la figure 1b, c'est le trajet émetteur-collecteur d'un transistor injecteur bipolaire $T'_i$, de type PNP, qui constitue la part essentielle du couplage entre la borne 3 de l'alimentation auxiliaire 20 connectée à la borne 5 du dispositif injecteur de courant 6 et la base du transistor $T_s$ connectée à la borne 7 de ce dispositif. Une résistance $R_E$ est cependant insérée en série dans la connexion de collecteur du transistor $T'_i$, résistance qui a pour rôle de limiter la valeur du courant de base du transistor $T_s$. Pour le reste, le dispositif d'injection de courant 6' de la figure 1b fonctionne de manière analogue à celui de la figure 1, le signal de commande de fonctionnement délivré au point de liaison D entre les résistances $R_p$ et $R_D$ étant appliqué à la base du transistor $T'_i$.

Un transistor de contrôle $T_i$, ici du type PNP, opposé à celui du transistor $T_s$ a son trajet émetteur-base relié en parallèle sur le trajet base-émetteur du transistor $T_s$, c'est-à-dire que son émetteur est relié à la base du transistor $T_s$, et sa base à l'émetteur du transistor $T_s$.

Le transistor de contrôle $T_c$ présente une résistance de base $R_b$. Le collecteur du transistor de contrôle $T_c$ est relié à une borne de contrôle C, laquelle est elle-même reliée à la masse par une résistance de contrôle $R_c$, de telle sorte qu'une tension de contrôle est disponible à la borne C, dans des conditions qui seront précisées dans la suite de la description.

Selon la figure 2a, le relais présente un transistor de protection $T_v$ à effet de champ MOS à enrichissement et à canal N, dont le trajet drain-source est inséré entre la grille du transistor injecteur de courant $T_i$ et la borne de commande D, son drain étant relié à la grille du transistor injecteur $T_i$, et sa source à la borne de commande D. La grille du transistor de protection $T_v$ est alimentée à la tension d'alimentation principale $V_{bat}$, de telle sorte que, si celle-ci vient à s'interrompre, aucun courant n'est délivré par le drain du transistor de protection $T_v$, ce qui désamorce le transistor $T_i$ et le transistor $T_s$. Bien entendu, si on ne souhaite pas protéger le circuit contre le débranchement de $V_{bat}$, le transistor $T_v$ peut être supprimé, la grille du transistor $T_i$ communiquant alors avec la borne D. Le collecteur du transistor de contrôle $T_c$ est relié à la borne de commande D par une diode $D_1$ disposée dans le sens normalement passant pour le courant issu du collecteur du transistor $T_c$, de manière à éviter un retour du courant. Comme pour la figure 1a, la borne de commande est reliée à la masse par une résistance $R_D$ lorsque l'interrupteur 8 est fermé.

On notera également à la figure 2a la présence de deux composants ($R_1$, $D_3$) dont la seule fonction est de procurer une sécurité en cas de surtension de la tension d'alimentation principale $V_{bat}$. La résistance $R_1$ est à cet effet disposée en série dans la grille du transistor $T_v$, et la diode $D_3$ entre la grille et la source de $T_v$, en inverse quand la tension $V_{bat}$ est dans le sens normal.

Deux variantes d'interrupteur sont représentées aux figures 3a et 3b. A la figure 3a, un transistor bipolaire $T_1$ reçoit sur sa base 9 un signal de commande, son émetteur étant à la masse et son collecteur étant relié à la borne de commande D par la résistance $R_D$. Selon la figure 3b, le transistor $T_1$ reçoit sur sa base 9 un signal de commande, mais son émetteur est relié à la masse par la résistance $R_D$, alors que son collecteur est en liaison directe avec la borne de commande D.

A la figure 3a, on a également représenté la forme du signal $V_9$, à appliquer à la base du transistor $T_1$ pour obtenir un contrôle de la conduction progressive du relais, équivalent à l'introduction en série avec $R_D$ d'une résistance de forte valeur que l'on diminue progressivement pendant un temps $t_1$ ce qui permet le contrôle de l'appel de courant dans la charge Z. La tension $V_9$ est sous forme d'une rampe, produisant une diminution progressive de $V_D$, puis passe brusquement au temps $t_1$ à sa valeur nominale, $V_D$ chutant alors à une valeur voisine de 0. Ceci n'introduit qu'un léger retard à l'éxécution de l'ordre.

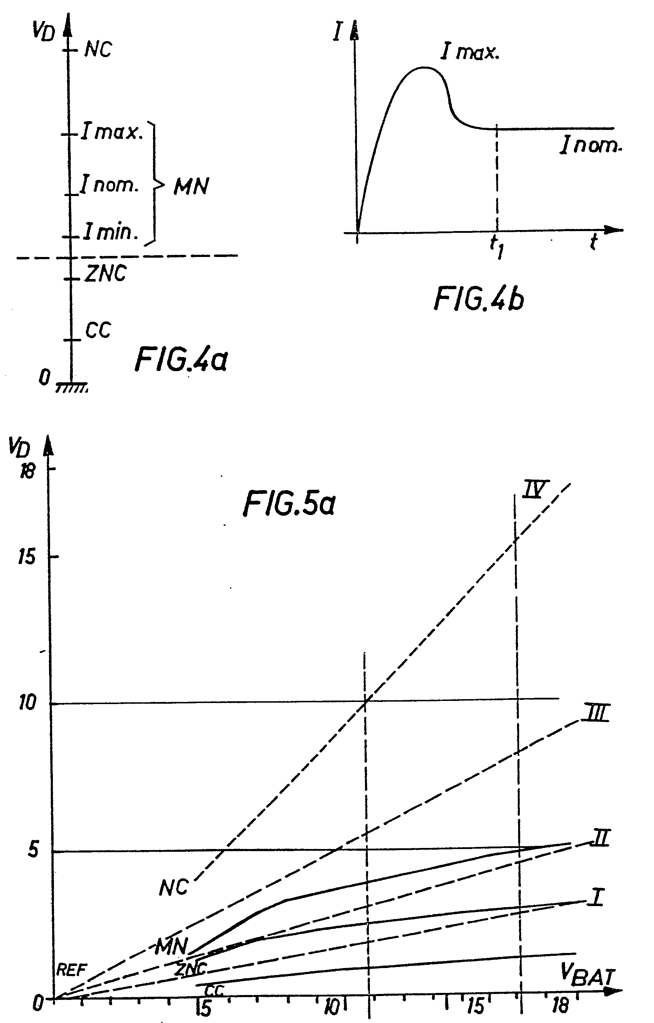

En se référant à la figure 4a, on va maintenant expliquer ce qui se produit au niveau de la borne de contrôle D de la figure 2a, selon les différents états du relais et de la charge Z.

Lorsque le relais n'est pas commandé (NC) interrupteur 8 ouvert, la source du transistor $T_v$ est à un potentiel élevé, $T_i$ et $T_s$ sont bloqués, et aucun courant ne circule dans el collecteur de $T_c$. $T_c$ ne consomme dans cette situation aucune puissance. On recueille à la borne de commande D une tension Vd élevée voisine de $V_{bat}$.

Lorsque le relais est commandé (interrupteur 8 fermé), et que l'état de la charge est normal (MN; $I_{min} \times I < I_{max}$) la tension $V_D$ s'établit à une valeur plus faible que précédemment et qui est d'autant plus élevée que I est plus proche de $I_{max}$. Ceci est dû au fait que le collecteur du transistor $T_c$ délivre dans $R_D$ un courant qui croît en fonction du courant I. Le courant maximal $I_{max}$ correspond (voir figure 4b) au cas de l'allumage d'une ampoule électrique, ou d'une charge inductive, le courant atteignant transitoirement un maximum avant de se stabiliser au courant nominal $I_{nom}$. Lorsque le relais est commandé et que l'état de la charge est anormal, on distingue les cas où celle-ci n'est pas connectée (par exemple ampoule de phare d'automobile hors d'usage) et le cas où celle-ci se trouve en court-circuit.

Dans le premier cas, à savoir charge non connectée (ZNC), le collecteur de $T_s$ débite sensiblement le courant d'injection vers la borne $V_{bat}$. L'émetteur de $T_s$ est pratiquement à la tension $V_{bat}$ et le transistor de contrôle $T_c$ génère sur la borne de contrôle D une tension $V_D$ très inférieure à celle du fonctionnement normal.

Dans le second cas, à savoir charge court-circuitée (CC), $T_s$ a son émetteur à la masse, le transistor de contrôle $T_c$ est saturé, et son collecteur délivre un courant encore plus faible que précédemment se traduisant sur la borne de commande D par une tension $V_D$ également plus faible que précédemment.

En résumé, dans la variante de la figure 2a, les états de fonctionnement normaux MN, (relais coupé, charge normale) produisent sur la borne de commande D des tensions $V_D$ situées dans une gamme élevée, alors que les incidents de fonctionnement (ZNC, CC) induisent sur celle-ci des tensions $V_D$ faibles. On remarquera que dans le cas de la figure 1a où les bornes C et D sont indépendantes, l'état où le relais est non commandé (NC) correspond à une tension nulle sur la borne C.

Le circuit de la figure 2a présente un autre avantage. Quand la tension de batterie $V_{bat}$ est présente, le transistor $T_v$ est équivalent à un interrupteur fermé, et $V_D$ commande la grille du transistor injecteur $T_i$. Si le courant tend à dépasser $I_{max}$, pour quelque raison que ce soit, le courant débité par le collecteur du transistor de contrôle $T_c$ augmente et donc la tension $V_D$, donc la tension de grille du transistor injecteur $T_i$ induisant un blocage progressif de celui-ci.

On notera qu'une résistance $R_x$ peut être insérée dans le collecteur du transistor de contrôle $T_c$. Dans l'état normal de la charge, le transistor $T_c$ n'est pas saturé et son collecteur est un générateur de courant, la résistance $R_x$ n'ayant pas d'influence sur la tension $V_D$. Par contre, en cas de court-circuit (cc), le transistor Tc ne fonctionne plus comme un générateur de courant et la résistance $R_x$ permet d'abaisser le potentiel $V_D$. Plus spécifiquement à la figure 2b, dans laquelle on néglige les chutes de tension des jonctions des éléments semi-conducteurs, $T_c$ est équivalent à une résistance variable commandée $R_T$ en parallèle avec $R_p \cdot R_x$ vient en série avec $R_T$.

En cas de fonctionnement normal, la résistance $R_T$ a une valeur élevée, traduisant le fonctionnement du transistor $T_c$ en générateur de courant. En cas de charge court-circuitée (cc), $R_T$ a une valeur faible.

A la figure 5a, on a représenté les valeurs des tensions $V_D$ recueillies à la borne de commande D dans les différentes configurations de la charge, à savoir court-circuit CC, charge non connectée ZNC, et de fonctionnement à l'état normal MN ($I_{nom}$) et NC, en fonction de tension $V_{bat}$ évoluant entre 5 et 18 V. On constate que ces différents courbes peuvent être discriminées par un réseau de droites séparatrices I, II, III, IV passant en première approximation par l'origine 0, la séparation étant d'autant plus grande que la tension $V_{bat}$ est importante.

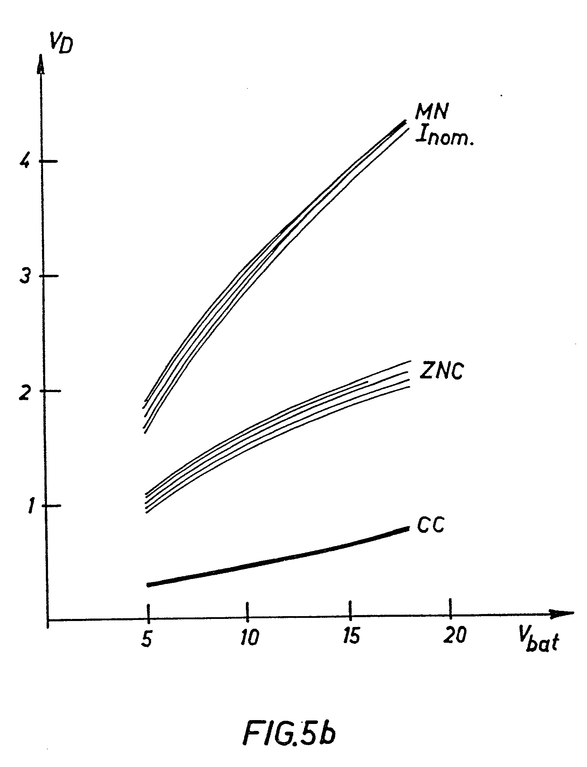

A la figure 5b, les valeurs des tensions $V_D$ sont représentées dans les états de marche normale ($I_{nom}$), charge non connectée (ZNC) et court-circuit (CC) en fonction des variations de la tension d'alimentation principale $V_{bat}$, le faisceau de courbes étant obtenu en faisant varier $\Delta V = V_{aux}-V_{bat}$ entre 1,5 et 2,5 V. On constate que le faisceau de courbes n'est pas très dispersé lorsque $\Delta V$ varie notablement.

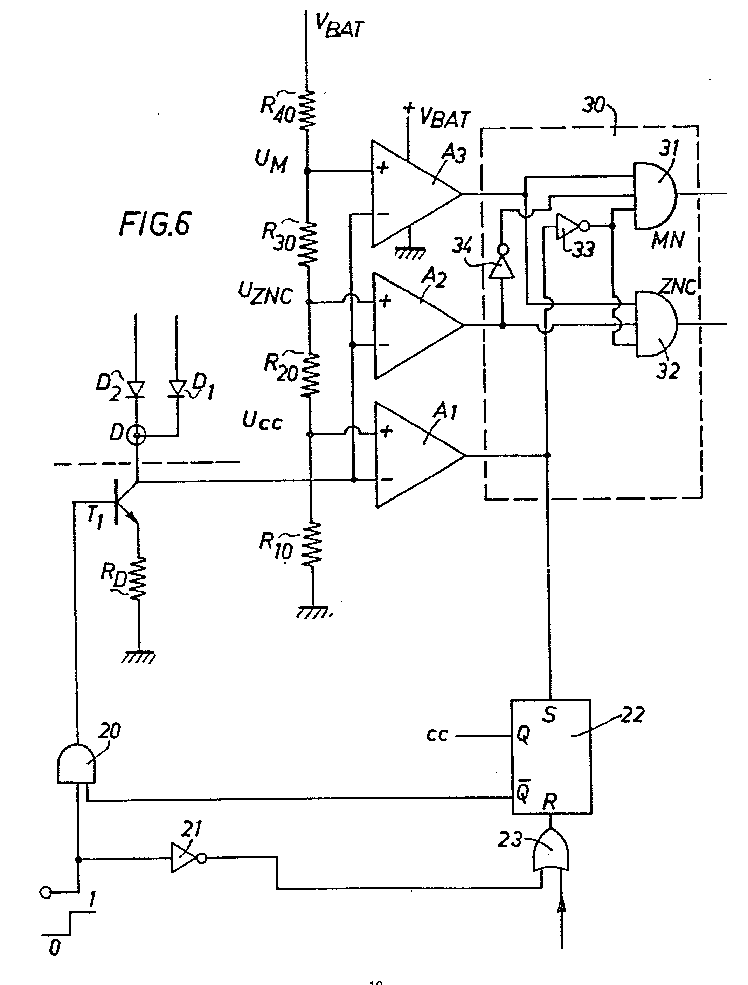

La figure 6 représente une logique que l'on peut associer au circuit de la figure 2a. La tension $V_D$ présente au point D est introduite à l'entrée inverseuse de trois comparateurs $A_1$, $A_2$, et $A_3$, alimentés sous une seule tension $V_{bat}$, de manière à fonctionner en tout ou rien en produisant à leur sortie soit une tension maximal correspondant à un niveau logique 1, soit 0 volt, correspondant à un niveau logique 0. Elle présente une échelle de résistances comportant quatre résistances $R_{10}$, $R_{20}$, $R_{30}$ et $R_{40}$ disposées en série entre une borne d'alimentation à la tension $V_{bat}$ et une borne de pôle commun. Le point commun entre les résistances $R_{10}$ et $R_{20}$ est raccordé à l'entrée non inverseuse du comparateur $A_1$, le point commun entre les résistances $R_{20}$ et $R_{30}$, à celle du comparateur $A_2$, et le point commun entre les résistances $R_{30}$ et $R_{40}$ à celle du comparateur $A_3$. De cette manière, l'entrée non inverseuse de $A_1$ reçoit une tension $U_{cc}$ supérieure à la tension présente sur la borne D en cas de court-circuit, mais inférieure à celle qui serait présente en cas de charge non connectée, l'entrée non inverseuse de $A_2$ reçoit une tension $U_{znc}$ supérieure à la tension présente sur la borne D en cas de charge non connectée, mais inférieure à celle qui serait présente en cas de courant normal dans la charge ($I = I_{nom}$), et l'entrée non inverseuse de $A_3$ reçoit une tension $U_M$ supérieure à la tension présente sur la borne D en cas de courant maximal dans la charge ($I = I_{max}$) et inférieure à celle qui serait présente en cas d'arrêt.

En conséquence, le comparateur $A_1$ délivre en sortie un niveau logique 1 en cas de court-circuit, le comparateur $A_2$ un signal logique 1 en cas de court-circuit ou de charge non connectée, et le comparateur $A_3$ un signal logique 1 en cas de court-circuit, de charge non connectée, ou de fonctionnement normal.

La discrimination des états est réalisée par un circuit logique 30 comprenant deux portes ET à trois entrées 31 et 32. La porte ET 31 reçoit à ses entrées la sortie du comparateur $A_3$ et celle après inversion respectivement par des inverseurs 33 et 34 des comparateurs $A_1$ et $A_2$. La porte ET 31 produit en conséquence à sa sortie un signal logique caractéristique de l'état normal de marche du relais. On notera que du point de vue logique, la liaison de la sortie $A_1$ inversée à la porte ET 31 est redondante, la sortie de l'amplificateur $A_2$ discriminant les cas où il y a court-circuit et charge non connectée.

La porte ET 32 reçoit à ses entrées la sortie des comparateurs $A_3$ et $A_2$ et celle, inversée par l'inverseur 33 du comparateur $A_1$. En conséquence, la porte ET 32 produit à sa sortie un signal caractéristique de l'état où la charge Z n'est pas connectée (ZNC).

Le signal de sortie de l'amplificateur $A_1$ est également utilisé pour arrêter le relais du fait du risque que fait courir au transistor $T_s$ un court-circuit de sa charge Z. Le signal de sortie de l'amplificateur $A_1$ est à cet effet introduit à l'entrée d'activation S' d'une bascule 22, laquelle mémorise l'apparition éventuelle d'un court-circuit. La mise en route du relais est alors réalisé de la manière suivante. Le signal de mise en marche est constitué par la présence d'un 1 logique à une entrée d'une porte ET 20 dont la sortie est reliée à la base du transistor $T_1$ qui est monté comme à la figure 3b. L'autre entrée de la porte ET 20 reçoit le signal présent à la sortie $\bar{Q}$ de la bascule 22, qui délivre un 0 logique en cas de court-circuit de la charge.

Le réarmement du relais après court-circuit peut avoir lieu de deux manières différentes. A cet effet, l'entrée R de remise à zéro de la bascule 22 est connectée à la sortie d'une porte OU 23 qui reçoit, soit le signal de mise en marche inversé par un inverseur 21, soit une commande logique de réarmement.

Si on alimente l'échelle de résistances $R_{10}$, $R_{20}$, $R_{30}$, $R_{40}$ par la tension $V_{bat}$, alors on peut choisir les résistances $R_{10}$, $R_{20}$, $R_{30}$ et $R_{40}$ de manière que $U_{cc}$, $U_{znc}$ et $U_M$ correspondent aux droites séparatrices I à III de la figure 5a. Une meilleure séparation aux tensions basses peut être obtenue en remplaçant $R_{10}$ par une résistance non linéaire telle qu'une diode ou en la mettant en série avec un tel élément.

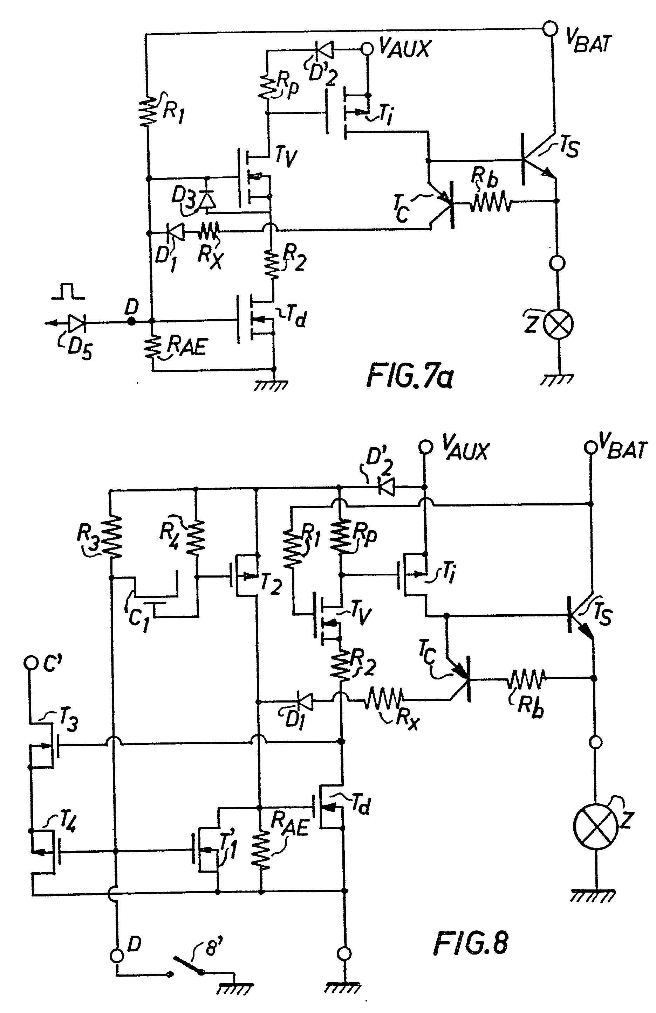

Selon le mode de réalisation de la figure 7a, le signal envoyé sur la borne de commande D à travers une diode d'isolement $D_5$ est reçu par la grille d'un transistor de commande $T_d$ à effet de champ MOS à enrichissement et à canal n dont le drain, à son tour, commande la grille du transistor injecteur $T_i$. Le relais est auto-entretenu et peut donc être commandé par une impulsion. Cette impulsion a une durée suffisante pour forcer la commande pendant la montée du courant dans la charge Z. La source du transistor de commande $T_d$ est reliée à la masse, alors que son drain est relié à la grille du transistor $T_i$ à travers le trajet source-drain du transistor de sécurité $T_v$, qui fonctionne comme interrupteur ouvert lorsque la tension d'alimentation principale $V_{bat}$ est absente, et fermé dans le cas contraire. Le transistor $T_v$ n'a lieu d'exister que si on souhaite une protection contre l'interruption de la tension d'alimentation principale $V_{bat}$. Cette fonction peut d'ailleurs être remplie par une résistance de limitation $R_2$ de faible valeur disposée entre le drain du transistor $T_d$ et la grille du transistor injecteur $T_i$. La résistance $R_2$ peut également être présente lorsqu'un transistor de sécurité $T_v$ est utilisé. On notera également la présence facultative d'une diode de protection $D'_2$, remplissant la même fonction que la diode $D_2$ de la figure 2a, et disposée en direct entre la borne d'alimentation à la tension auxiliaire $V_{aux}$ et la résistance $R_p$.

Le collecteur du transistor de contrôle $T_c$ est relié à la borne de commande D à travers une diode $D_1$ comme dans le cas de la figure 2a, mais dans le but de remplir une fonction non plus de discrimination des différents états du relais, mais d'auto-entretien de celui-ci.

Pour ce faire, on dispose une résistance dite d'auto-entretien $R_{AE}$ entre la grille G du transistor de commande $T_d$ et la masse. La résistance $R_x$ remplit la même fonction que dans les cas précédents.

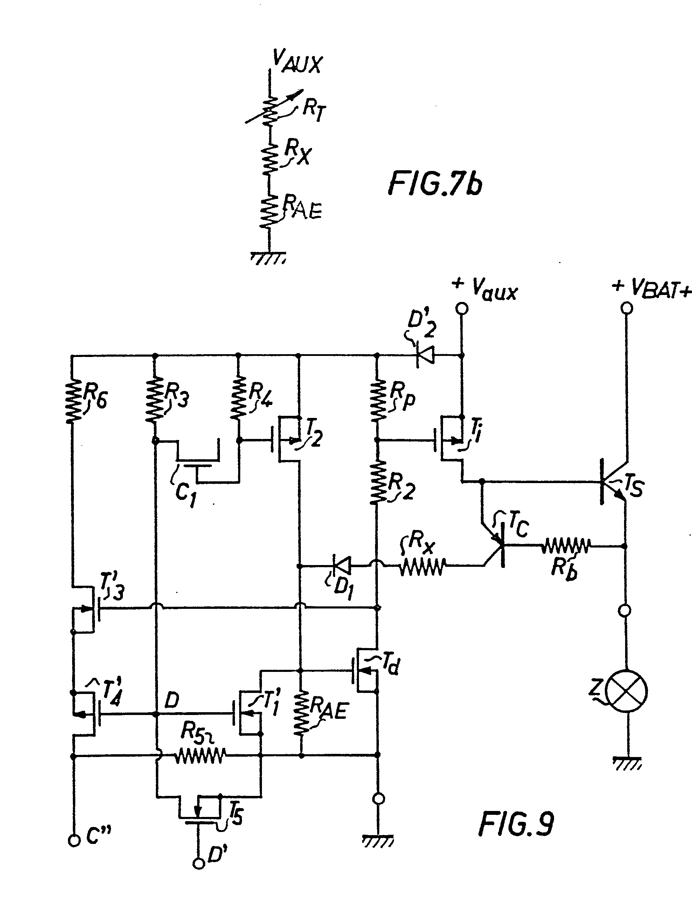

Suivant le schéma équivalent de la figure 7b la résistance commandée $R_T$ est en série avec les résistances $R_x$ et $R_{AE}$. En cas de défaut, elles forment un pont diviseur permettant de faciliter le blocage du transistor de commande $T_d$. Le choix des résistances $R_x$ et $R_{AE}$ dépend du gain du transistor de contrôle $T_c$ et de la tension de seuil du transistor de commande $T_d$.

En cas de réalisation du relais sous forme intégrée monolithique, il convient de noter que le transistor $T_c$ sera en général un transistor latéral de gain inférieur ou égal à 30. Dans un tel cas, une résistance $R_b$ de l'ordre de 1 k$\Omega$ est convenable. La valeur de $R_b$ une fois fixée, le réglage de l'auto-entretient est obtenu en jouant sur la valeur de $R_{AE}$, de manière que, dès que la tension de la borne D approche celle correspondant à la condition de charge non connectée, le transistor de commande $T_d$ soit désamorcé. On notera également le circuit de protection du transistor $T_v$. En cas de surtension au niveau de l'alimentation $V_{bat}$, la tension source-grille du transistor $T_v$ est limitée à la tension de claquage d'une diode $D_3$ en inverse, le courant étant limité par une résistance $R_1$.

Le mode de réalisation de la figure 8 permet de commander le relais par fermeture d'un interrupteur de commande 8'. Il comporte à cet effet un générateur d'impulsion calibrée conprenant deux résistances $R_3$ et $R_4$ ayant une électrode commune raccordée à la source d'alimentation auxiliaire $V_{aux}$, leur autre électrode étant connectée respectivement à chacune des électrodes d'un condensateur $C_1$, par exemple la capacité interne d'un transistor MOS intégré. La borne commune au condensateur $C_1$ et à la résistance $R_4$ est reliée à la grille d'un transistor $T_2$ à effet de champ MOS du type à enrichissement et à canal p, dont la source est alimentée à la tension auxiliaire $V_{aux}$, et le drain qui constitue la sortie du générateur d'impulsion est relié à la grille du transistor de commande $T_d$. La borne commune au condensateur $C_1$ et à la résistance $R_3$ est reliée à la borne de commande D. Lorsque celle-ci est mise à la masse par fermeture de l'interrupteur 8', la grille du transistor $T_2$ se trouve momentanément au potentiel 0, et le condensateur $C_1$ dont une électrode est à la masse, se charge à travers $R_4$ avec une constante de temps $R_4 C_1$. Le transistor $T_2$ se trouve donc avoir son trajet émetteur-drain passant tant que son potentiel de grille n'est pas remonté à un niveau suffisant, ce qui se produit au bout d'un temps donné par charge du condensateur $C_1$. On recueille de ce fait une impulsion sur le drain de $T_2$ alimentant la grille du transmission sur le drain de $T_2$ alimentant la grille du transistor de commande Td de manière à débloquer celui-ci. La jonction grille-drain de $T_2$ équivaut à la diode $D_5$ de la figure 7a. Après disparition de l'impulsion sur le drain de $T_2$, le relais est auto-entretenu comme dans le cas de la figure 7a.

Un transistor de verrouillage $T'_1$ à effet de champ MOS à enrichissement et à canal n a son trajet drain-source connecté aux bornes de la résistance d'auto-entretien $R_{AE}$, sa source étant reliée à la masse. La grille du transistor $T'_1$ est reliée à borne de commande D. Lorsque l'interrupteur 8' est ouvert, la grille du transistor $T'_1$ est à un potentiel élevé et le transistor de verrouillage $T'_1$ court-circuite la résistance d'auto-entretien $R_{AE}$, ce qui met la grille du transistor de commande $T_d$ à la masse d'ou résulte la désactivation du relais. Par contre, lorsque l'interrupteur 8' est fermé, la grille du transistor de verrouillage $T'_1$ est à la masse et la résistance $R_{AE}$ n'est plus court-circuitée.

Le circuit de la figure 8 représente également une borne logique de contrôle à deux transistors $T_3$ et $T_4$ à effet de champs MOS à enrichissement dont les canaux sont des types opposés. Le transistor $T_3$ à canal n, a son drain relié à la borne logique de contrôle C', sa grille au drain du transistor de commande $T_d$ et sa source à celle du transistor $T_4$ à canal p dont la grille est connectée à la borne de commande D, et le drain à la borne de pôle commun. La borne logique C' fonctionne selon la table de vérité suivante:

| | |
|---|---|
| Arrèt (8' ouvert) | 1 |
| Marche (8' fermé) | 1 |
| Marche + ZNC | 0 |
| Marche + CC | 0 |

Le circuit de la figure 9 se distingue du précédent tout d'abord par la présence d'une borne logique de commande D' reliée à la grille d'un transistor logique $T_5$, à effet de champ MOS du type à enrichissement.

Si, comme représenté, celui-ci est à canal n, sa source étant à la masse et son drain relié à la borne de commande D, un 1 logique sur la grille du transistor $T_5$ rend son trajet émetteur-drain conducteur et provoque la mise en marche du relais. Si le transistor $T_5$ est à canal p, avec sa source reliée à la borne de commande D, et son drain à la masse, la commande s'effectue sur la borne logique D' selon une logique inverse.

Il se distingue ensuite par une variante du circuit logique de contrôle fonctionnant selon une logique inverse de celle de la figure précédente.

Les transistors T'$_3$ et T'$_4$ sont raccordés de la même façon que précédemment à ceci près que le drain du transistor T$_4$, constitue une bonne logique de contrôle C", et est relié à masse par une résistance de division R$_5$, de manière à être compatible avec des niveaux logiques (par exemple TTL) alors que le drain du transistor T'$_3$ est raccordé à la tension d'alimentation auxiliaire V$_{aux}$, par une résistance de polarisation R$_6$.

**Revendications**

1. Relais statique pour courant continu sous basse tension, destiné à l'alimentation d'une charge (Z), comprenant un transistor bipolaire de sortie (T$_s$) d'un premier type de conductivité (n) dont l'émetteur est connecté à une borne de sortie destinée à alimenter la charge (Z), laquelle est reliée par ailleurs à un pôle commun d'alimentation, dont le collecteur est relié à une borne dite principale d'alimentation destinée à être connectée à l'autre pôle de ladite alimentation, et dont la base est alimentée par le trajet principal de courant d'un transistor injecteur de courant (T$_i$), lequel présente une électrode de commande qui, lorsqu'elle est actionnée à partir d'une borne de commande entraîne sa mise en conduction ainsi que celle du transistor bipolaire de sortie (T$_s$) caractérisé en ce qu'il comporte un transistor bipolaire du second type de conductivité opposé audit premier type, dit transistor de contrôle (T$_c$) dont le trajet émetteur-base augmenté d'une résistance de base (R$_b$) est connecté en parallèle sur le trajet base-émetteur du transistor bipolaire de sortie (T$_s$) et dont le collecteur produit un signal représentatif de l'état de la charge.

2. Relais statique selon la revendication 1, caractérisé en ce que ledit transistor injecteur de courant (T$_i$) est relié à une borne d'alimentation auxiliaire.

3. Relais statique selon une des revendications 1 ou 2, caractérisé en ce que ledit transistor injecteur de courant (T$_i$) est un transistor à effet de champ MOS, du type à enrichissement et à canal du second type de conductivité (p) et sa grille qui constitue ladite électrode de commande est reliée par l'intermédiaire d'une résistance de polarisation (R$_p$) à sa source, son drain alimentant la base du transistor bipolaire de sortie (T$_s$).

4. Relais statique selon la revendication 3, caractérisé en ce que le drain du transistor injecteur de courant (T$_i$) est directement relié à la base du transistor bipolaire de sortie (T$_s$), la résistance interne (R$_{on}$) du transistor injecteur de courant tenant lieu de résistance de limitation pour le courant base du transistor de sortie (T$_s$).

5. Relais statique selon une des revendications 1 à 4, caractérisé en ce que le collecteur du transistor de contrôle (T$_c$) est reliée à la borne de commande par une première diode de protection (D$_1$) disposée dans le sens normalement passant pour le courant issu du collecteur du transistor de contrôle (T$_c$), de telle sorte que la borne de commande (D) a également pour fonction de délivrer un signal de contrôle.

6. Relais statique selon la revendication 5 caractérisé en ce qu'il comporte un transistor de protection (T$_v$) à effet de champ MOS dont la grille est connectée à la borne principale d'alimentation, dont la source est reliée à la borne de commande et dont le drain est relié à l'électrode de commande du transistor injecteur de courant (T$_i$).

7. Relais statique selon la revendication 6 caractérisé en ce qu'entre la source du transistor de protection (T$_v$) et la borne de commande est disposée une deuxième diode de protection (D$_2$), montée dans le sens normalement passant du transistor de protection (T$_v$).

8. Relais statique selon une des revendications 6 ou 7 caractérisé en ce qu'il comporte une troisième diode de protection (D$_3$) disposée en parallèle sur l'espace grille-source de transistor de protection (T$_v$) et montée dans le sens inverse du sens passant de celuici, et en ce que la liaison de la grille vers la borne principale d'alimentation comporte en série une résistance de protection (R$_1$).

9. Relais statique selon une des revendications 5 à 8 caractérisé en ce qu'il comporte un circuit de contrôle (A$_1$, A$_2$, A$_3$, 30) recevant le signal de contrôle présent à la borne de commande (D) et le comparant à une pluralité de tensions de référence (U$_{cc}$, U$_{znc}$, U$_m$) obtenues par division de la tension d'alimentation principale et correspondant aux différents états de fonctionnement, et un circuit d'inhibition (20, 22) de la mise en marche du relais quand un état de court-circuit (CC) de la charge (Z) est détecté par le circuit de contrôle (A$_1$, A$_2$, A$_3$, 30).

10. Relais statique selon une des revendications 1 à 4 caractérisé en ce qu'il comporte un transistor de commande (T$_d$) dont la source est reliée à une borne de pôle commun, dont le drain est relié à l'électrode de commande du transistor injecteur de courant (T$_i$), et dont la grille est commandée à partir de la borne de commande (D) et est reliée d'une part à la borne de mode commun par une résistance d'auto-entretien (R$_{AE}$) et d'autre part au collecteur du transistor de contrôle (T$_c$) via une quatrième diode disposée dans le sens normalement passant pour le courant issu du collecteur du transistor de contrôle (T$_c$), de manière à appliquer sur la grille du transistor de commande (T$_d$) une tension d'auto-entretien dans l'état normal de la charge (Z).

11. Relais statique selon la revendication 10 caractérisé en ce qu'il comporte une résistance de limitation (R$_2$) disposée en série entre le drain de transistor de commande (T$_d$) et l'électrode de commande du transistor injecteur de courant (T$_i$).

12. Relais statique selon une des revendications 10 ou 11 caractérisé en ce qu'il comporte un transistor de protection (T$_v$) à effet de champ MOS dont la grille est connectée à la borne principale d'alimentation (V$_{bat}$), dont la source est reliée au drain du transistor de commande (Td) et dont le drain est relié à l'électrode de commande du transistor injecteur de courant (T$_i$).

13. Relais statique selon une des revendications 10 à 12, caractérisé en ce qu'il comporte un transistor de verrouillage, à enrichissement et à canal du premier type dont le trajet drain-source ($T_1$) est branché en parallèle sur la résistance d'auto-entretien ($R_{AE}$), et dont la grille est reliée à ladite borne de commande (D), et un circuit logique formé de deux transistors de contrôle MOS à effet de champ en série, à enrichissement et dont le type de canal est opposé l'un par rapport à l'autre, le premier ($T_4$) ayant sa grille reliée à la borne de commande et le second ($T_3$) ayant sa grille reliée à la grille du transistor injecteur de courant ($T_i$), de manière à produire sur une borne logique de contrôle (C') un signal de contrôle à deux états.

14. Relais statique selon la revendication 13 caractérisé en ce qu'il comporte un circuit générateur d'impulsion calibrée comprenant une première et une deuxième résistance ($R_3$, $R_4$) chacune ayant une électrode connectée à la borne d'alimentation auxiliaire ($V_{aux}$), et son autre électrode étant reliée respectivement à une électrode d'un condensateur ($C_1$) l'électrode commune au condensateur ($C_1$) et à la deuxième résistance ($R_4$) étant reliée à la grille d'un transistor à effet de champ MOS à enrichissement et à canal du second type de conductivité (p) dont la source est reliée à la borne d'alimentation auxiliaire ($V_{aux}$) et le drain à la grille du transistor de commande ($T_d$), le point commun au condensateur ($C_1$) et à la première résistance ($R_3$) étant relié à la borne de commande (D) de telle sorte que, lorsque la borne de commande (D) est mise à la masse, le circuit générateur d'impulsion produise une impulsion de mise en marche.

15. Relais statique selon une des revendications 13 ou 14 caractérisé en ce que le premier transistor ($T_4$) du circuit logique a un canal du second type de conductivité (p) et a son drain relié à la borne de pôle commun et sa source à celle du deuxième transistor ($T_3$) du circuit logique, ce dernier ayant son drain connecté à la borne logique de contrôle.

16. Relais statique selon une des revendications 13 ou 14 caractérisé en ce que le premier transistor ($T_4$) du circuit logique a un canal du second type de conductivité (p), et a son drain connecté à la borne logique de contrôle, et sa source à celle du second transistor ($T_3$) dont le drain est connecté à la borne d'alimentation auxiliaire ($V_{aux}$).

17. Relais statique selon une des revendications 13 à 16 caractérisé en ce que la borne de commande est attaquée par un transistor de commande logique ($T_5$) à effet de champ MOS à enrichissement dont le trajet drain-source est branché entre la borne de pôle commun et la borne de commande (D) de telle sorte que sa grille reçoive une commande logique (TTL).

18. Relais statique selon une des revendications 10 à 16 caractérisé en ce qu'il comporte une seconde résistance d'auto-entretien ($R_x$) disposée entre le collecteur du transistor de contrôle ($T_c$) et l'électrode non à la masse de la première résistance d'auto-entretien ($R_{AE}$), de manière à former avec celle-ci un pont diviseur.

**Patentansprüche**

1. Statisches Relais für Niederspannungs-Gleichstrom zur Speisung einer Belastung (Z), mit einem bipolaren Ausgangstransistor ($T_s$) von einem ersten Leitfähigkeitstyp (n), dessen Emitter mit einer Ausgangsklemme zum Speisen der Belastung (Z) verbunden ist, die ausserdem an eine gemeinsame Versorgungsklemme angeschlossen ist, dessen Kollektor mit einer Hauptversorgungsklemme verbunden ist, die an den anderen Versorgungspol anzuschliessen ist, und dessen Basis aus dem Hauptstromweg eines Strominjektortransistors ($T_i$) versorgt wird, der eine Steuerelektrode enthält, die bei ihrer Aktivierung aus einer Steuerklemme ihren leitenden Zustand sowie den leitenden Zustand des bipolaren Ausgangstransistors ($T_s$) bewirkt, dadurch gekennzeichnet, dass das Relais einen bipolaren Transistor von dem dem ersten Leitfähigkeitstyp entgegengesetzten zweiten Leitfähigkeitstyp enthält und mit Steuertransistor ($T_c$) angegeben wird, dessen mit einem Basiswiderstand ($R_b$) erhöhte Emitter-Basisstrecke zur Basis-Emitterstrecke des bipolaren Ausgangstransistors ($T_s$) parallel geschaltet ist und dessen Kollektor ein den Ladungszustand darstellendes Signal erzeugt.

2. Statisches Relais nach Anspruch 1, dadurch gekennzeichnet, dass der Strominjektortransistor ($T_i$) mit einer Hilfsversorgungsklemme verbunden ist.

3. Statisches Relais nach einem der Ansprüche 1 oder 2, dadurch gekennzeichnet, dass der Strominjektortransistor ($T_i$) ein MOS-Feldeffekttransistor vom Anreicherungstyp mit einem Kanal vom zweiten Leitfähigkeitstyp (p) ist und sein Gate, das die Steuerelektrode darstellt, über einen Polarisationswiderstand ($R_p$) mit seiner Quelle verbunden ist, wobei sein Abzug die Basis des bipolaren Ausgangstransistors ($T_s$) speist.

4. Statisches Relais nach Anspruch 3, dadurch gekennzeichnet, dass der Abzug des Strominjektortransistors ($T_i$) mit der Basis des bipolaren Ausgangstransistors ($T_s$) direkt verbunden ist, wobei der Innenwiderstand ($R_{on}$) des Strominjektortransistors den Begrenzungswiderstand für den Basisstrom des Ausgangstransistors ($T_s$) ersetzt.

5. Statisches Relais nach einem der Ansprüche 1 bis 4, dadurch gekennzeichnet, dass der Kollektor des Steuertransistors ($T_c$) mit der Steuerklemme über eine erste Schutzdiode ($D_1$) verbunden ist, die in Durchlassrichtung des vom Kollektor des Steuertransistors ($T_c$) abgegebenen Stroms derart angeordnet ist, dass die Steuerklemme (D) zudem die Aufgabe der Lieferung eines Steuersignals hat.

6. Statisches Relais nach Anspruch 5, dadurch gekennzeichnet, dass es einen MOS-Feldeffekttransistor ($T_v$) enthält, dessen Gate mit der Hauptversorgungsklemme verbunden ist, dessen Quelle mit der Steuerklemme verbunden ist und dessen Abzug an die Steuerelektrode des Strominjektortransistors $(T_i)$ angeschlossen ist.

7. Statisches Relais nach Anspruch 6, dadurch gekennzeichnet, dass zwischen der Quelle des Schutztransistors $(T_v)$ und der Steuerklemme eine zweite Schutzdiode $(D_2)$ angeordnet ist, die in der normalen Durchgangsrichtung des Schutztransistors $(T_v)$ aufgebracht ist.

8. Statisches Relais nach einem der Ansprüche 6 oder 7, dadurch gekennzeichnet, dass eine dritte Schutzdiode $(D_3)$ in Parallelschaltung mit dem Gate-Quellenraum des Schutztransistors $(T_v)$ und im umgekehrten Sinn in bezug auf die Durchgangsrichtung dieses Transistors aufgebracht ist, und dass die Verbindung des Gates zur Hauptversorgungsklemme einen Schutzwiderstand $(R_1)$ in Serienschaltung enthält.

9. Statisches Relais nach einem der Ansprüche 5 bis 8, dadurch gekennzeichnet, dass eine Steuerschaltung $(A_1, A_2, A_3, 30)$ vorgesehen ist, die das Steuersignal an der Steuerklemme $(D)$ empfängt und ihn mit einer Anzahl von Bezugsspannungen $(U_{cc}, U_{znc}, U_m)$ vergleicht, die durch Teilung der Hauptspeisespannung erhalten wurden und mehreren Betriebszuständen entsprechen, und eine Blockierungsschaltung $(20, 22)$ für die Aktivierung des Relais enthält, wenn die Steuerschaltung $(A_1, A_2, A_3, 30)$ einen Kurzschlusszustand $(CC)$ der Belastung $(Z)$ detektiert.

10. Statisches Relais nach einem der Ansprüche 1 bis 4, dadurch gekennzeichnet, dass ein Steuertransistor $(T_d)$ vorgesehen ist, dessen Quelle mit einer gemeinsamen Polklemme verbunden ist, dessen Abzug an die Steuerelektrode des Strominjektortransistors $(T_i)$ angeschlossen ist, und dessen Gate von der Steuerklemme $(D)$ gesteuert wird, dabei einerseits an die gemeinsame Betriebsklemme über einen Selbsthaltewiderstand $(R_{AE})$ und andererseits an den Kollektor des Steuertransistors $(T_c)$ über eine vierte Diode angeschlossen ist, die in der normalen Durchgangsrichtung für den vom Kollektor des Steuertransistors $(T_c)$ abgegebenen Strom derart angeordnet ist, dass an das Gate des Steuertransistors $(T_d)$ eine Selbsthaltespannung im normalen Zustand der Belastung $(Z)$ angelegt werden kann.

11. Statisches Relais nach Anspruch 10, dadurch gekennzeichnet, dass ein Begrenzungswiderstand $(R_2)$ vorgesehen ist, der zwischen dem Abzug des Steuertransistors $(T_d)$ und der Steuerelektrode des Strominjektortransistors $(T_i)$ in Reihe geschaltet ist.

12. Statisches Relais nach einem der Ansprüche 10 oder 11 dadurch gekennzeichnet, dass ein MOS-Feldeffekttransistor $(T_v)$ vorgesehen ist, dessen Gate an die Hauptversorgungsklemme $(V_{bat})$ angeschlossen ist, dessen Quelle mit dem Abzug des Steuertransistors $(T_d)$ und dessen Abzug mit der Steuerelektrode des Strominjektortransistors $(T_i)$ verbunden sind.

13. Statisches Relais nach einem der Ansprüche 10 bis 12, dadurch gekennzeichnet, dass ein Verriegelungstransistor vom Anreicherungstyp und mit einem Kanal vom ersten Leitfähigkeitstyp vorgesehen ist, dessen Abzug/Quellenstrecke $(T_1)$ in Parallelschaltung mit dem Selbsthaltewiderstand $(R_{AE})$ abgezweigt ist, und dessen Gate mit der Steuerklemme $(D)$ verbunden ist, und eine logische aus zwei MOS-Feldeffekttransistoren in Reihenschaltung gebildete Schaltung vom Anreicherungstyp enthält, dessen Kanäle einem dem anderen entgegengesetzt leitfähig sind, wobei der erste Kanal $(T_4)$ mit seinem Gate an die Steuerklemme und der zweite Kanal $(T_3)$ mit seinem Gate an das Gate des Strominjektortransistors $(T_i)$ derart angeschlossen sind, dass an einer logischen Steuerklemme $(C')$ ein Steuersignal für beide Zustände erzeugt wird.

14. Statisches Relais nach Anspruch 13, dadurch gekennzeichnet, dass ein kalibrierter Impulsgenerator mit einem ersten und einem zweiten Widerstand $(R_3, R_4)$ vorgesehen ist, von denen je eine Elektrode mit der Hilfsversorgungsklemme $(V_{aux})$ und jeweils die andere Elektrode mit einer Elektrode eines Kondensators $(C_1)$ verbunden ist, wobei die Elektrode, die dem Kondensator $(C_1)$ und dem zweiten Widerstand $(R_4)$ gemeinsam ist, mit dem Gate eines MOS-Feldeffekttransistors vom Anreicherungstyp mit einem Kanal vom zweiten Leitfähigkeitstyp $(p)$ gemeinsam ist, dessen Quelle an die Hilfsversorgungsklemme $(V_{aux})$ und den Abzug an das Gate des Steuertransistors $(T_d)$ angeschlossen sind, wobei der gemeinsame Punkt des Kondensators $(C_1)$ und des ersten Widerstandes $(R_3)$ an die Steuerklemme $(D)$ derart angeschlossen ist, dass beim Verbinden der Steuerklemme $(D)$ mit Masse die Impulsgeneratorschaltung einen Aktivierungsimpuls erzeugt.

15. Statisches Relais nach einem der Ansprüche 13 oder 14, dadurch gekennzeichnet, dass der erste Transistor $(T_4)$ der logischen Schaltung einen Kanal vom zweiten Leitfähigkeitstyp $(p)$ enthält, und mit seinem Abzug an die gemeinsame Polklemme und mit seiner Quelle an die des zweiten Transistors $(T_3)$ der logischen Schaltung angeschlossen sind, wobei der Abzug der letztgenannten Schaltung an die logische Steuerklemme angeschlossen ist.

16. Statisches Relais nach einem der Ansprüche 13 oder 14, dadurch gekennzeichnet, dass der erste Transistor $(T_4)$ der logischen Schaltung einen Kanal vom zweiten Leitfähigkeitstyp $(p)$ besitzt und mit seinem Abzug an die logische Steuerquelle und mit seiner Quelle an die des zweiten Transistors $(T_3)$ angeschlossen sind, dessen Abzug mit der Hilfsversorgungsklemme $(V_{aux})$ verbunden ist.

17. Statisches Relais nach einem der Ansprüche 13 bis 16, dadurch gekennzeichnet, dass die Steuerklemme mit einem logischen MOS-Feldeffektsteuertransistor $(T_5)$ vom Anreicherungstyp angesteuert wird, dessen Abzug/Quellenstrecke zwischen der gemeinsamen Polklemme und der Steuerklemme $(D)$ derart abgezweigt wird, dass sein Gate einen logischen Befehl (TTL) empfängt.

18. Statisches Relais nach einem der Ansprüche 10 bis 16, dadurch gekennzeichnet, dass ein

zweiter Selbsthaltewiderstand $(R_x)$ zwischen dem Kollektor des Steuertransistors $(T_c)$ und der nicht an Masse des ersten Selbsthaltewiderstands $(R_{AE})$ liegenden Elektrode derart angeordnet ist, dass damit eine Teilerbrücke gebildet wird.

## Claims

1. A static relay for low DC-voltages to be supplied to a load (Z) comprising a bipolar output transistor $(T_s)$ of a first (n) conductivity type, whose emitter is connected to an output terminal to which the load (Z) is to be connected, which is further connected to a common supply terminal, whose collector is connected to a main supply terminal and whose base is fed by means of the main current path of a current injection transistor $(T_i)$, which has a control electrode which, when it is operated upon via a control terminal, causes this transistor and also the bipolar output transistor $(T_s)$ to become conducting, characterized in that it comprises a bipolar detection transistor $(T_c)$ of the second conductivity type opposite to the said first type, whose emitter-base path, to which a base resistor $(R_b)$ is added, is connected parallel to the base-emitter path of the bipolar output transistor $(T_s)$ while its collector produces a signal representative of the state of the load.

2. A static relay as claimed in Claim 1, characterized in that the said current injection transistor is connected to an auxiliary supply terminal.

3. A static relay as claimed in Claim 1 or 2, characterized in that the said current injection transistor $(T_i)$ is a MOS field effect transistor of the enhancement type having a channel of the second (p) conductivity type, whose gate, which constitutes the said control electrode, is connected through a polarization resistor $(R_p)$ to its source, while its drain feeds the base of the bipolar output transistor $(T_s)$.

4. A static relay as claimed in Claim 3, characterized in that the drain of the current injection transistor $(T_i)$ is directly connected to the base of the bipolar output transistor $(T_s)$, the internal resistance $(R_{on})$ of the current injection transistor serving as a current limiting resistor for the base current of the output transistor $(T_s)$.

5. A static relay as claimed in any one of Claims 1 to 4, characterized in that the collector of the detection transistor $(T_c)$ is connected to the control terminal through a first protection diode $(D_1)$ arranged in the normally forward direction for the current originating for the collector of the detection transistor $(T_c)$ in a manner such that the control terminal (D) also serves to deliver a detection signal.

6. A static relay as claimed in Claim 5, characterized in that it comprises a MOS field effect protection transistor $(T_v)$, whose gate is connected to the main supply terminal, whose source is connected to the control terminal and whose drain is connected to the control electrode of the current injection transistor $(T_i)$.

7. A static relay as claimed in Claim 6, characterized in that a second protection diode $(D_2)$ connected in the normally forward direction of the protection transistor $(T_v)$ is arranged between the source of the protection transistor $(T_v)$ and the control terminal.

8. A static relay as claimed in any one of claims 6 or 7, characterized in that it comprises a third protection diode $(D_3)$ connected between the gate and the source of the protection transistor $(T_v)$ and arranged in a direction opposite to the forward direction of this transistor, and in that the connection between the gate and the main supply terminal includes in series a protection resistor $(R_1)$.

9. A static relay as claimed in any one of Claims 5 to 8, characterized in that it comprises a direction circuit $(A_1, A_2, A_3, 30)$ receiving the detection signal present at the control terminal and comparing it with a plurality of reference voltages $(U_{cc}, U_{znc}, U_m)$ obtained by division of the voltage applied to the main supply terminal and corresponding to the different operating states and a circuit (20, 22) inhibiting the activation of the relay when a shortcircuit state (CC) of the load (Z) is detected in the control circuit $(A_1, A_2, A_3, 30)$.

10. A static relay as claimed in any one of Claims 1 to 4, characterized in that it comprises a control transistor $(T_d)$, whose source is connected to the common terminal, whose drain is connected to the control electrode of the current injection transistor $(T_i)$ and whose gate is controlled via the control terminal (D) and is connected on the one hand to the common terminal via a self-maintenance resistor $(R_{AE})$ and on the other hand to the collector of the detection transistor $(T_c)$ via a fourth diode connected in the normally forward direction for the current originating from the collector of the control transistor $(T_c)$ in a manner such that a self-maintenance voltage is applied to the gate of the control transistor $(T_2)$ in the normal state of the load (Z).

11. A static relay as claimed in Claim 10, characterized in that it comprises a limiting resistor $(R_2)$ connected in series between the drain of the control transistor $(T_d)$ and the control electrode of the current injection transistor $(T_i)$.

12. A static relay as claimed in any one of Claims 10 or 11, characterized in that it comprises a MOS field effect protection transistor $(T_v)$, whose gate is connected to the main supply terminal $(V_{bat})$, whose source is connected to the drain of the control transistor $(T_d)$ and whose drain is connected to the control electrode of the current injection transistor $(T_i)$.

13. A static relay as claimed in any one of Claims 10 to 12, characterized in that it comprises a locking transistor of the enhancement type having a channel of the first conductivity type, whose drain-source path $(T_1')$ is connected parallel to the self-maintenance resistor $(R_{AE})$ and whose gate is connected to the said control terminal (D), and a logic circuit formed by two series-connected MOS field effect control transistors of the enhancement type whose channels have opposite types, the first transistor ($T_4$) having its gate connected to the control terminal and the second transistor ($T_3$) having its gate connected to the gate of the current injection transistor ($T_i$) in a manner such that a control signal having two states is produced at a logic control terminal ($C'$).

14. A static relay as claimed in Claim 13, characterized in that it comprises a calibrated pulse generator comprising a first and a second resistor ($R_3$, $R_4$) each having an electrode connected to the auxiliary supply terminal ($V_{aux}$), its other electrode being connected to a respective electrode of a capacitor ($C_1$), while the electrode common to the capacitor ($C_1$) and to the second resistor ($R_4$) is connected to the gate of a MOS field effect transistor of the enhancement type having a channel of the second conductivity type (p), whose source is connected to the auxiliary supply terminal ($V_{aux}$) and whose drain is connected to the gate of the control transistor ($T_d$), the junction between the capacitor ($C_1$) and the first resistor ($R_3$) being connected to the control terminal (D) in a manner such that, when the control terminal (D) is connected to ground, the pulse generator circuit produces an activation pulse.

15. A static relay as claimed in any one of Claims 13 or 14, characterized in that the first transistor ($T_4$) of the logic circuit has a channel of the second conductivity type (p), while its drain is connected to the common terminal and its source is connected to that of the second transistor ($T_3$) of the logic circuit, the drain of the latter being connected to the logic control terminal.

16. A static relay as claimed in any one of Claims 13 or 14, characterized in that the first transistor ($T_4$) of the logic circuit has a channel of the second conductivity type (p), while its drain is connected to the logic detection terminal and its source is connected to that of the second transistor ($T_3$), whose drain is connected to the auxiliary supply terminal ($V_{aux}$).

17. A static relay as claimed in any one of Claims 13 to 16, characterized in that the control terminal is acted upon by a MOS field effect logic control transistor ($T_5$) of the enhancement type, whose drain source path is connected between the common connection terminal and the control terminal (D) in a manner such that its gate receives a logic control signal (TTL).

18. A static relay as claimed in any one of Claims 10 to 16, characterized in that it comprises a second self-maintenance resistor ($R_x$) arranged between the collector of the detection transistor ($T_c$) and the non-grounded electrode of the first self-maintenance resistor ($R_{AE}$) in a manner such that it forms therewith a voltage divider.

FIG.1a

FIG.1b

FIG.2a

FIG.2b

FIG.3a

FIG.3b

FIG.4a

FIG.4b

FIG.5a

FIG.5b

FIG.6

FIG.7a

FIG.8

FIG.7b

FIG.9